# EUROPÄISCHE PATENTSCHRIFT

(11) **EP 2 297 760 B1**
(45) Veröffentlichungstag und Bekanntmachung des Hinweises auf die Patenterteilung: **18.01.2012**
(21) Anmeldenummer: 09777178.6
(22) Anmeldetag: 14.07.2009
(51) Int. Cl.: H01H 23/28, H03K 17/97

(54) **WIPPSCHALTER**
ROCKER SWITCH
INTERRUPTEUR À BASCULE

(30) Priorität: 15.07.2008 DE 102008033738
(43) Veröffentlichungstag der Anmeldung: 23.03.2011
(73) Patentinhaber: CoActive Technologies, LLC, Greenwich, CT 06830 (US)
(72) Erfinder: GILLMANN, Uwe, 12439 Berlin (DE); MAURER, Rainer, 10435 Berlin (DE); STOFFERS, Michael, 13129 Berlin (DE)
(74) Vertreter: Fuhlendorf, Jörn
(86) Internationale Anmeldenummer: PCT/EP2009/005108
(87) Internationale Veröffentlichungsnummer: WO 2010/006762

(56) Entgegenhaltungen:
- WO-A-2007/116132
- DE-C1- 10 117 597
- FR-A- 698 317

## Beschreibung

Die vorliegende Erfindung bezieht sich auf einen Wippschalter nach dem Oberbegriff des Anspruchs 1.

Bei einem derartigen aus der DE 101 17 597 C1 bekannten Wippschalter sind die freien Federendschenkel einerseits und der herausgeführte mittige Federschenkel andererseits der gegenläufig doppelt gewickelten Feder gegenüber der Längserstreckung der Drehachse derart zueinander angeordnet, dass sich zwischen ihnen ein stumpfer Winkel in einem Bereich von 120° und 180° in eingebautem Zustand bildet. Aufgrund der sich dadurch ergebenden Angriffsrichtungen der an den Federendschenkeln und am dem mittigen Federschenkel beim Auslenken angreifenden Kräfte bewirkt die daraus resultierende Kraft, dass die gewickelten Federbereiche gegen die Unterseite der Drehachse reiben. Daraus resultiert für die jeweilige Rückbewegung eine ungenaue Mittenstellung. Außerdem ist die Hysteresekurve (Kraft F in Abhängigkeit vom Betätigungswinkel α) erstens sehr breit und zweitens bei den beiden Federendschenkeln unterschiedlich.

Aufgabe der vorliegenden Erfindung ist es deshalb, einen Wippschalter der eingangs genannten Art zu schaffen, dessen Mittenstellung prägnanter und perfekter mechanisch einstellbar ist.

Zur Lösung dieser Aufgabe sind bei einem Wippschalter der genannten Art die Anspruch 1 angegebenen Merkmale vorgesehen. Durch die erfindungsgemäßen Maßnahmen ist erreicht, dass die einzelnen Federteile der doppelt gegenläufig gewickelten Feder aufgrund der parallel gegengerichteten Angriffsfläche der Federkräfte beim Auslenken an der Drehachse nicht mehr reiben können, da die daraus resultierende Federkraft von der Unterseite der Drehachse wegweist. Dadurch ist die Mittenstellung bei der jeweiligen Rückbewegung mechanisch genauer und von selbst einstellbar, was darüber hinaus den Vorteil hat, dass das elektrisch darüber gelegte Mittenfenster genauer kalibriert werden und das System feinfühliger arbeiten kann. Der Wegfall der Reibkomponente ergibt darüber hinaus den Vorteil, dass bei der Betätigung eine genauere Auflösung zwischen Mittenstellung und äußerem Druckpunkt oder Rastung erfolgt. Die Hystereseschleife bzw. - kurve ist sehr schmal und für beide Federendschenkel gleich.

In weiterer vorteilhafter Ausgestaltung sind die Merkmale nach Anspruch 2 vorgesehen, was zu dem Vorteil führt, dass die Auslenkkraft in beiden Bewegungsrichtungen identisch ist, so dass ein Versatz der Federvorspannung vermieden ist.

In weiterer Ausgestaltung der Erfindung sind die Merkmale nach Anspruch 3 vorgesehen, was zu einer weiteren Fixierung der Feder gegenüber der Drehachse führt. Dabei können die Merkmale nach Anspruch 4 vorgesehen sein.

Eine robuste Drehachse ergibt sich aus den Merkmalen nach Anspruch 5. Dabei ist es zweckmäßig, die Merkmale gemäß Anspruch 6 und/oder 7 vorzusehen, was zu einer konstruktiven Vereinfachung für die Anlage der betreffenden Federschenkel führt. Eine vorteilhafte Lagerungspaarung mit erhöhter Lebensdauer der Drehachse ergibt sich durch die Merkmale nach Anspruch 8.

Mit den Merkmalen nach Anspruch 9 ist eine bevorzugte Anordnung der Sensoren erreicht. Dadurch ist die elektrische Signalauswertung, die vom Ringmagneten ausgelöst wird, besser, weil die gleichen Magnetfeldlinien beide Sensoren durchfluten. Der untere Sensor erhält dabei nur einen leicht schwächeren Magnetfluss. Das System aus Ringmagnet und Sensoranordnung ist dabei stabiler gegenüber Magnetflussstörungen.

Eine vorteilhafte Fixierung des Ringmagneten ergibt sich nach den Merkmalen des Anspruchs 10.

Mit den Merkmalen nach Anspruch 11 ist eine vorteilhafte Abschirmung der Sensoranordnung gegenüber Permanentmagnetflüssen benachbarter Wippschalter, so sie denn in Reihe angeordnet sind, gegeben. Die Elektronik auf der Leiterplatte ist von seitlichen Magnetfeldern weitestgehend geschützt. Eine bevorzugte Ausgestaltung der Abschirmung ergibt sich dabei nach den Merkmalen des Anspruchs 12.

Weitere Einzelheiten der Erfindung sind der folgenden Beschreibung zu entnehmen, in der die Erfindung anhand des in der Zeichnung dargestellten Ausführungsbeispieles näher beschrieben und erläutert ist. Es zeigen:
- Figur 1: in auseinandergezogener schematischer perspektivischer Darstellung einen Wippschalter gemäß einem bevorzugten Ausführungsbeispiel vorliegender Erfindung,
- Figur 2: einen Schnitt längs der Linie II-II der Figur 1, jedoch in zusammengebautem Zustand des Wippschalters,
- Figur 3: einen Schnitt längs der Linie III-III der Figur 2,
- Figur 4: in auseinandergezogener perspektivischer Darstellung das Schaltelement des Wippschalters,
- Figur 5: einen Schnitt längs der Linie V-V der Figur 4 durch die Drehachse,
- Figur 6: eine Ansicht gemäß Pfeil VI der Figur 4, jedoch in zusammengebautem Zustand der Drehachse,
- Figur 7: eine Ansicht gemäß Pfeil VII der Figur 6, und
- Figur 8: in schematischer perspektivischer Darstellung ein im unteren Gehäuseteil verwendetes Abschirmblech.

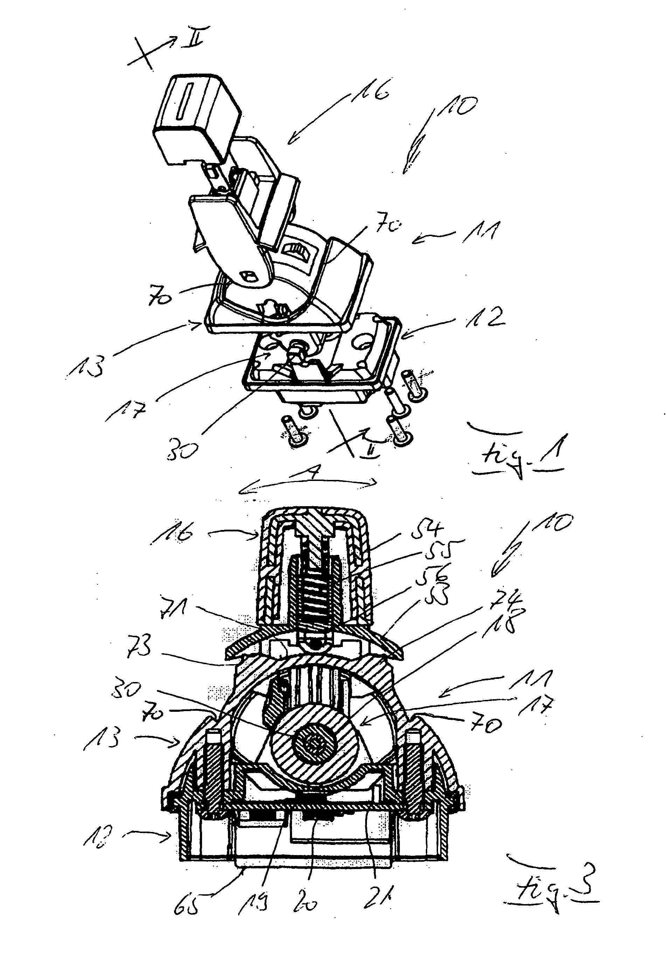

Der in den Figuren 1 bis 3 dargestellte Wippschalter 10 besitzt ein länglich rechteckförmiges Schaltergehäuse 11, das aus einem an der Oberseite offenen unteren Gehäuseteil 12 und einem oberen Gehäusedeckel 13 aufgebaut ist, ferner ein bewegbares Schaltelement 14, das in das Gehäuse 11 aus Kunststoff einbaubar ist, sowie eine Betätigungswippe 16, die von außerhalb über den Gehäusedeckel 13 hinweg mit dem Schaltelement 14 bewegungsschlüssig verrastbar ist, sowie außer der vorgenannten mechanischen Schaltereinheit eine elektrische kontaktlose Schaltereinheit 17, deren einer Teil 18 am bewegbaren Schaltelement 14 und deren anderer Teil 19 an einer gedruckten Leiterplatte 21 gehalten ist, die mit der Unterseite des unteren Gehäuseteils 12 des Schaltergehäuses 11 vorzugsweise lösbar befestigbar ist.

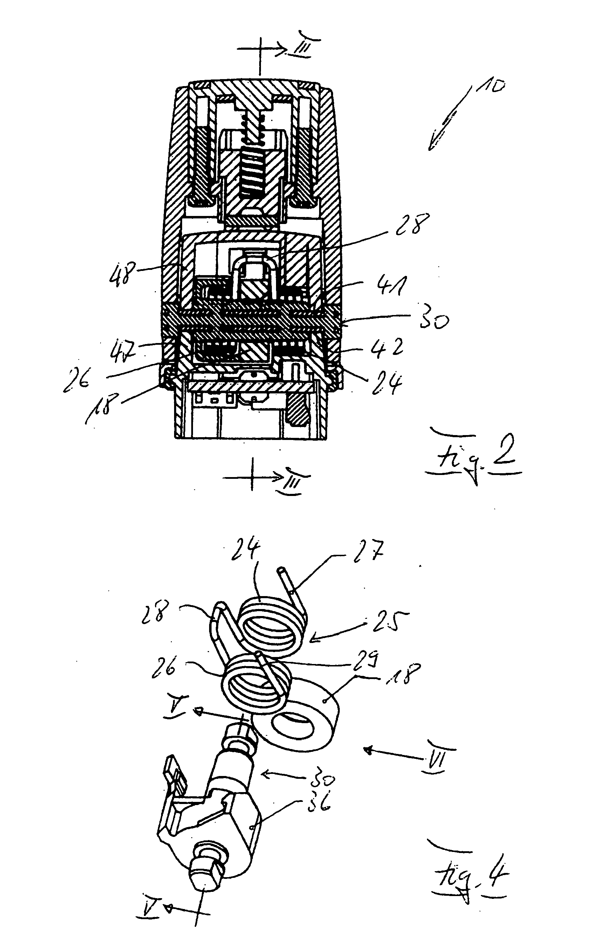

Gemäß den Figuren 4 bis 7 ist die Drehachse 30 aus einem Kunststoff einstückig geformt, welches Kunststoffteil achsmittig einen hohlen Metallschaft 31 besitzt, der durch Umfangsbohrungen hindurch auch im Hohlraum von dem Kunststoff der Drehachse 30 ausgefüllt ist. Beide aus dem Schaltergehäuse 11 herausragenden freien Kunststoffenden der Drehachse 30 sind mit Schlüsselflächen 33 versehen. Anschließend an die Schlüsselflächen 33 besitzt die Drehachse 30 einen vom hier freiliegenden Metallschaft 31 gebildeten zylindrischen Lagerbereich 34, der jeweils zwischen zwei einander gegenüberliegenden halbschalenartigen Ausnehmungen 42 und 41 von unterem Gehäuseteil 12 bzw. oberem Gehäusedeckel 13 drehbar gelagert aufgenommen und gehalten ist. Zwischen den beiden zylindrischen Lagerbereichen 34 erstreckt sich eine mit diesen drehfeste durchmessergrößere außenumfangsseitig leicht konisch ausgebildete Aufnahme 35. An einem an den Lagerbereich 34 angrenzenden Längsbereich der Aufnahme 35, zu dem der Außenumfangskonus ansteigt, ist die Aufnahme 35 von einem einstückig angesetzten topfförmigen Ansatz 36 umgeben, dessen Außenfläche zylindrisch und dessen Innenfläche 37 von innen nach außen sich konisch erweiternd erstreckt. Der Boden des Ansatzes 36 ist mit der Aufnahme 35 einstückig geformt. An einem Umfangsbereich des topfförmigen Ansatzes 36 ist ein in axialer Richtung die Öffnungsseite verlängernder und tangential über den Außenumfang vorstehender Anlagesteg 38 und an einem bezüglich der Drehachsenrichtung gegenüberliegendem Bereich des topfförmigen Ansatzes 36, dessen Boden zugewandt ist, ein zweiter Anlagesteg 39 tangential über den Außenumfangsbereich abstehend angeordnet, wobei dem Anlagesteg 39 benachbart in dem Mantel des topfförmigen Ansatzes 36 ein axial verlaufender Schlitz 40 vorgesehen ist. Die beiden Anlagestege 38 und 39 verlaufen somit tangential zur Drehachse 30 und zueinander parallel, sind jedoch in axialer Richtung versetzt zueinander angeordnet.

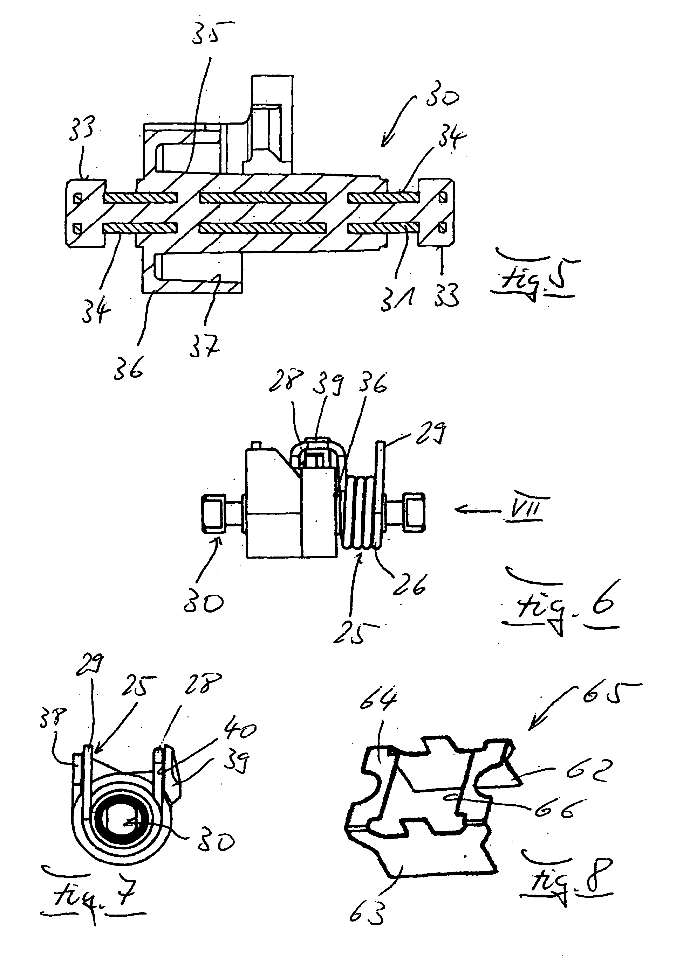

Über die konisch ansteigende Aufnahme 35 der Drehachse 30 ist eine doppelt gegenläufig gewickelte Wendelfeder 25 geschoben, deren Federteile 24 und 26 in einem Abstand zueinander angeordnet und durch einen U-förmigen abgebogenen Mittenschenkel 28 miteinander verbunden sind. Jeder Federteil 24, 26 besitzt einen freien Endschenkel 27 bzw. 29. Mit dem Aufschieben der Wendelfeder 25 über die Aufnahme 35 der Drehachse von dem Ansatz 36 abgewandten Ende her und in den topfförmigen Ansatz 36 werden der Mittenschenkel 28 und der Endschenkel 27 des vorausgeführten Federteils 24 unter Vorspannung dieses Federteils 24 auf die Auflagestege 38 bzw. 39 des Ansatzes 36 gebracht. Auf diese Weise verlaufen der Mittenschenkel 28 und der Endschenkel 27 des vorgespannten Federteils 24 einander gegenüberliegend parallel, wie dies beispielsweise aus Figur 7 hervorgeht.

Das oben offene untere Gehäuseteil 12 besitzt ein ortsfestes Auflagepult 43 im Bereich einer Querseite 44 und einen ortsfesten Auflageansatz 45 an seiner anderen Querseite 46. Senkrecht zu den beiden Querseiten 44 und 46 verlaufen Längsseiten 47 und 48, die mit den unteren halbschalenförmigen Ausnehmungen 41 versehen sind.

Die mit der Wendelfeder 25 bestückte Drehachse 30 wird in das untere Gehäuseteil 12 derart eingelegt, dass einerseits die Lagerbereiche 34 in den halbschalenförmigen Ausnehmungen 41 des unteren Gehäuseteils 12 liegen und andererseits der Mittenschenkel 28 mit seinem dem Auflagesteg 38 benachbarten Bereich am ortsfesten Auflagepult 43 in aufrechter Ruheposition anliegt und der Endschenkel 29 des Federteils 26 der Wendelfeder 25 an den schlitzförmigen Auflageansatz 45 des unteren Gehäuseteils 12 vorgespannt liegt. Die Vorspannung der entsprechend geformten Wendelfeder 25 wird dadurch bewirkt bzw. gehalten, dass auch der Endschenkel 29 des Federteils 26 in eine aufrechte Lage, das heißt parallel zu dem anderen Endschenkel 27 und dem Mittenschenkel 28 gebracht bzw. fixiert ist.

Der Wippschalter 10 bzw. dessen elektrische Schaltereinheit 17 besitzt einen ringförmigen Dauermagneten 18, der zwischen den beiden Federteilen 24 und 26 der Wendelfeder 25 gebracht und mit diesen auf die konische Aufnahme 35 der Drehachse 30 geschoben ist. Der Ringmagnet 18, der in montiertem Zustand diametral magnetisiert wird, ist mit der Drehachse 30 bzw. deren Aufnahme 35 drehfest verbunden, beispielsweise mittels Verkleben. Es ist auch möglich, den Ringmagneten 18 an die Stirn des Ansatzes 36 zur drehfesten Verbindung zu kleben. Die elektrische Schaltereinheit 17 besitzt außerdem beim Ausführungsbeispiel zwei einander gegenüberliegend angeordnete Hallsensoren 19 und 20, die mittels ihrer Anschlussbeine an der Leiterplatte 21 mechanisch und elektrisch befestigt sind. Mit anderen Worten, der eine Hallsensor 19 befindet sich auf der dem unteren Gehäuseteil 12 zugewandten Seite der Leiterplatte, während sich der andere Hallsensor 20 an der gegenüberliegenden Fläche der Leiterplatte befindet. Die Leiterplatte 21 verbindet in nicht dargestellter Weise weitere elektrische und elektronische Bauteile elektrisch und hält diese mechanisch. Die genannten elektrischen und elektronischen Bauteile sind mit dem Hallsensor an der Seite der Leiterplatte 21 angeordnet, die dem unteren Gehäuseteil 12 abgewandt ist. Die so bestückte Leiterplatte 21 ist mit dem Boden 50 des unteren Gehäuseteils 12 fest verbunden, vorzugsweise verschraubt, wobei der erste Hallsensor 19 in einer Ausnehmung 52 des Bodens 50 in seiner Dicke teilweise aufgenommen ist. Die Schrauben zur Befestigung der Leiterplatte am unteren Gehäuseteil dienen gleichzeitig zur Verbindung des unteren Gehäuseteils 12 mit dem oberen Gehäusedeckel 13. Die Lage der beiden Hallsensoren 19 und 20 auf der Leiterplatte 21 ist gemäß den Figuren 2 und 3 derart, dass sie unmittelbar unterhalb des Ringmagneten 18 liegen.

Die Leiterplatte 21 befindet sich innerhalb eines von der Unterseite des Bodens 50 des unteren Gehäuseteils 12 abstehenden Rahmenteils 61, dessen Längsseitenwände innenseitig von den Seitenteilen 62 und 63 eines Abschirmblechs 65 bedeckt sind. Das Abschirmblech 65 ist gemäß Figur 9 als U-förmiges Rinnenteil ausgebildet, dessen die beiden Seitenteile 62 und 63 bildender Boden 64, der sich zwischen Leiterplatte 21 und Boden 50 des unteren Gehäuseteils 12 befindet, mit einer Ausnehmung 66 versehen ist.

Die Betätigungswippe 16 besitzt einen in Seitenansicht und in Draufsicht gesehen rechteckförmigen Aufbau, wobei die beiden Seitenwangen 51 und 52 mittig durch einen Zwischenboden 53 miteinander verbunden sind. Der obere freie Endbereich der Seitenwangen 51 und 52 ist von einer Haube 54 überdeckt, in welcher ein mittels einer Druckfeder 55 beaufschlagter Nocken 56 in Richtung des Pfeiles R hin und her bewegbar ist. Der Nocken 56 liegt unter der Wirkung der Druckfeder 55, die sich an der ortsfesten Haube 54 anlegt, gegen den Zwischenboden 53. Der Nocken 56 ist durch einen quer zur Bewegungsrichtung R angeordneten Stift gebildet. Die unteren freien Enden der beiden Seitenwände 51 und 52 sind mit Schlüsselöffnungen 58 versehen, die über die jeweilige Schlüsselfläche 33 der freien Enden der Drehachse 30 drehschlüssig rasten.

Gemäß Figur 3 ist der obere Gehäusedeckel 13 an seiner oberen kreisförmigen Mantelfläche 71 als Kulissenbahn ausgebildet. Hierzu besitzt die Mantelfläche 71 an zwei winklig auseinanderliegenden Bereichen Nocken 73 und 74, die beim Ausführungsbeispiel gegenüber einer durch den Wippschalter 10 verlaufenden Mittelebene denselben winkligen Abstand besitzen. Beim Ausführungsbeispiel ist der winklige Abstand der Scheitel der Nocken 73 und 74 jeweils 36° von der Mittenebene. Beim Ausführungsbeispiel sind die Nocken 73 und 74 gleich ausgebildet, das heißt sie besitzen in von der Mittenebene ausgehender Bewegungsrichtung A jeweils eine Auflaufschräge 75, einen sich daran anschließenden Scheitel 76 und eine Ablaufschräge 77. Die Ablaufschräge 77 kann dabei mit einer Rastvertiefung versehen sein. Es versteht sich, dass es auch möglich ist, die Mantelfläche 71 nur mit einem einzigen Nocken 73 oder 74 zu versehen.

Somit kann die Betätigungswippe 16 aus ihrer Nullstellung in der Mittenebene nach links und/oder rechts in Richtung des Doppelpfeils A bewegt werden, wobei bei Auflaufen des Querstiftes 56 auf die Auflaufschräge 75 ein erster fühlbarer Druckpunkt erreicht ist und nach Erreichen der Höhe und vor Beginn des Scheitels 76 eine Verrastung beginnt, die nach Überqueren des Scheitels 76 in der Rastvertiefung 78 am in Bewegungsrichtung abgewandten Bereich des Scheitels 76 endet. In dieser Endrastung wird die Betätigungswippe 16 gehalten. Aus dieser Rastvertiefung 78 kann die Betätigungswippe 16 durch aktiven Druck in Gegenrichtung entrastet werden, so dass die Betätigungswippe 16 nach Rückführen über den Scheitel 76 sich aufgrund der Druckfeder 55 selbsttätig in ihre Ruhestellung zurückbewegt. Der Bereich der Kulissenbahn 72 zwischen den Nocken 73 und 74 ist beim Ausführungsbeispiel über die Kreisbahn verlaufend eben. Der wesentliche Antrieb der Rückführung der Betätigungswippe 16 erfolgt durch die in Bewegungsrichtung einer weiteren ansteigenden Vorspannung ausgesetzten Wendelfeder 25. Die maximale Endstellung der Betätigungswippe 16 ist durch einen gegenüber der Mantelfläche 71 in Richtung der Drehachse 30 vorstehenden Rand 70 des oberen Gehäusedeckels 13 gebildet.

Die Betätigungswippe 16 besitzt von den beiden Seitenwänden 51 und 52 in Bewegungsrichtung ausgehende dachförmige Stege 57, die in Ausgangs-Ruhestellung der Betätigungswippe 16 die Nocken 73 und 74 frei beweglich überdecken.

Die Verbindung zwischen dem unteren Gehäuseteil 12 und dem oberen Gehäusedeckel 13 ist durch verschiedene Dichtkanten gegeben. Der obere Gehäusedeckel 13 besitzt an seinem Boden einen umlaufenden Rahmen, in den der Boden des unteren Gehäuseteils 12 eingebracht ist, wobei an den Boden umlaufend randseitig sowohl zum Rahmen des oberen Gehäusedeckels 13 als auch zur Seite des Rahmenteils 61 hin im Querschnitt dreieckförmige Dichtstege angeformt sind. Damit ist nicht nur eine Abdichtung zwischen oberem und unterem Gehäuseteil 13, 12 gegeben, sondern auch eine Abdichtung des unteren Gehäuseteils 12 gegenüber einer nicht dargestellten Trägerplatte, die mehrere nebeneinander angeordnete Wippschalter 10 tragen kann. Eine weitere an das Kunststoffgehäuse angeformte Dichtung kann an dem freien Ende eines Wandteils des unteren Gehäuseteils 12 vorgesehen sein, das mit einem entsprechenden Wandteil des oberen Gehäusedeckel 13 aneinanderliegend verbunden ist.

Wenn auch gemäß dem dargestellten Ausführungsbeispiel die Auslenkung der Betätigungswippe 16 in einem Bereich von +/-40° erfolgt, versteht es sich, dass bei Änderung des betreffenden Randbereichs des oberen Gehäusedeckels 13 ein größerer Auslenkwinkel von bis zu +/- 80° erreicht werden kann. In entsprechender Weise kann der obere Gehäusedeckel 13 an seiner Mantelfläche 71 mit weiteren Nocken versehen sein.

## Patentansprüche

1. Wippschalter (10), mit einer mechanischen Schaltereinheit aus einem Schaltergehäuse (11), in dem ein federbelastetes hin und her bewegbares Schaltelement (14) gelagert ist, und mit einer mit dem Schaltelement (14) verbundenen Betätigungswippe (16), wobei das Schaltelement (14) einen im Schaltergehäuse (11) drehbar gelagerte Drehachse (30) aufweist, die von einer doppelt gegenläufig gewickelten Feder (25) umgeben ist, die im Schaltergehäuse (11) vorgespannt gehalten ist und von der einer der beiden freien Federendschenkel (27, 29) ortsfest im Schaltergehäuse (11) und der andere an einem mit der Drehachse (30) drehfest verbundenen ersten Arm (38) gelagert ist und ein herausgeführter U-förmiger mittiger Federschenkel (28) sowohl ortsfest im Schaltergehäuse (11) als auch an einem mit der Drehachse (30) drehfest verbundenen zweiten Arm (39) gelagert ist, sowie mit einer elektrischen Schaltereinheit (17), **dadurch gekennzeichnet, dass** die beiden freien Federendschenkel (27, 29) und der herausgeführte U-förmige mittige Federschenkel (28) in eingebautem Zustand bezüglich der Längsausdehnung der Drehachse (30) einander gegenüberliegend im Wesentlichen in parallelen Ebenen verlaufend angeordnet sind.

2. Wippschalter nach Anspruch 1, **dadurch gekennzeichnet, dass** die beiden gegenläufig gewickelten Federteile (24, 26) der Feder (25) gleiche Windungszahl von vorzugsweise drei Windungen aufweisen.

3. Wippschalter nach Anspruch 1 oder 2, **dadurch gekennzeichnet, dass** derjenige gewickelte Federteil (24), der mit dem mit der Drehachse (30) drehfest verbundenen Federendschenkel (27) versehen ist, in einem etwa topfförmig konzentrischen und an einem Umfangsbereich axial geschlitzten Ansatz (36) außenumfangsseitig festgelegt aufgenommen ist.

4. Wippschalter nach Anspruch 3, **dadurch gekennzeichnet, dass** der Ansatz (36) eine den axialen Schlitz (40) für den Federendschenkel außenseitig begrenzende Tangentialanlage aufweist.

5. Wippschalter nach mindestens einem der Ansprüche 1 bis 4, **dadurch gekennzeichnet, dass** die Drehachse (30) ein metallisches Röhrchen (31) aufweist, das mit Kunststoff vorzugsweise außen- und innenseitig umspritzt ist.

6. Wippschalter nach Anspruch 3 und/oder 4 und Anspruch 5, **dadurch gekennzeichnet, dass** der Ansatz (36) Teil der Kunststoffumspritzung der Drehachse (30) ist.

7. Wippschalter nach mindestens einem der Ansprüche 3 bis 6, **dadurch gekennzeichnet, dass** der Ansatz (36) an einem Umfangsbereich eine axiale und tangential gerichtete Verlängerung aufweist, die eine Anlagefläche für den vorgespannten mittigen Federschenkel (28) bildet.

8. Wippschalter nach Anspruch 6, **dadurch gekennzeichnet, dass** die Außenumfangsseite des Metallröhrchens (31) im Schaltergehäuse (11) gelagert ist.

9. Wippschalter, bei dem die elektrische Schaltereinheit (17) einen mit der Drehachse (30) bewegbaren permanent magnetisierten Ringmagneten (18) aufweist, nach mindestens einem der vorhergehenden Ansprüche, **dadurch gekennzeichnet, dass** dem Ringmagnet (18) zwei Sensoren (19, 20) zugeordnet sind, die einander gegenüberliegend an der Ober- bzw. Unterseite einer Leiterplatte (21) unterhalb eines Gehäusebodens angeordnet sind.

10. Wippschalter nach Anspruch 9, **dadurch gekennzeichnet, dass** der Ringmagnet (18) auf der Drehachse (30) und/oder am Ansatz vorzugsweise mittels Kleben drehfest fixiert ist.

11. Wippschalter nach mindestens einem der vorhergehenden Ansprüche, bei dem das Schaltergehäuse (11) ein unteres und ein oberes Gehäuseteil (12, 13) aufweist, **dadurch gekennzeichnet, dass** das untere Gehäuseteil (12) einen von der Unterseite seines Bodens senkrecht abstehenden Rahmen aufweist, in dem die Leiterplatte (21) am Boden befestigt angeordnet ist, und dass zumindest teilweise innerhalb des Rahmens und zwischen Leiterplatte (21) und Boden ein Abschirmblech (65) angeordnet ist.

12. Wippschalter nach Anspruch 11, **dadurch gekennzeichnet, dass** das Abschirmblech (65) mit Kunststoff umspritzt ist.

## Claims

1. A rocker switch (10) including a mechanical switch unit of a switch housing (11) in which a spring-loaded reciprocating switching element (14) is supported, and including an operating rocker (16) connected to the switching element (14), wherein the switching element (14) has a rotary axle (30) pivoted in the switch housing (11), which is surrounded by a doubly oppositely coiled spring (25), which is held biased in the switch housing (11) and of which one of the two free spring end legs (27, 29) is stationarily supported in the switch housing (11) and the other one is supported on a first arm (38) rotationally fixedly connected to the rotary axle (30), and a led-out U-shaped central spring leg (28) is supported both stationarily in the switch housing (11) and on a second arm (39) rotationally fixedly connected to the rotary axle (30), as well as including an electrical switch unit (17), **characterized in that** the two free spring end legs (27, 29) and the led-out U-shaped central spring leg (28) are disposed substantially running in parallel planes opposing each other with respect to the longitudinal extension of the rotary axle (30) in the installed state.

2. The rocker switch according to claim 1, **characterized in that** the two oppositely coiled spring parts (24, 26) of the spring (25) have the same turn number of preferably three turns.

3. The rocker switch according to claim 1 or 2, **characterized in that** the coiled spring part (24) provided with the spring end leg (27) rotationally fixedly connected to the rotary axle (30) is received fixedly on the outer circumference in an approximately pot-shaped concentric lug (36) axially slotted in a circumferential region.

4. The rocker switch according to claim 3, **characterized in that** the lug (36) has a tangential abutment externally limiting the axial slot (40) for the spring end leg.

5. The rocker switch according to at least one of claims 1 to 4, **characterized in that** the rotary axle (30) has a metallic tube (31) overmolded with plastic preferably on the outside and inside.

6. The rocker switch according to claim 3 and/or 4 and claim 5, **characterized in that** the lug (36) is a part of the plastic overmold of the rotary axle (30).

7. The rocker switch according to at least one of claims 3 to 6, **characterized in that** the lug (36) has an axial and tangentially directed extension in a circumferential region, which forms an abutting surface for the biased central spring leg (28).

8. The rocker switch according to claim 6, **characterized in that** the outer circumference side of the metal tube (31) is supported in the switch housing (11).

9. The rocker switch, in which the electrical switch unit (17) has a permanently magnetized annular magnet (18) movable with the rotary axle (30), according to at least one of the preceding claims, **characterized in that** two sensors (19, 20) are associated with the annular magnet (18), which are disposed opposing each other on the upper and lower side of a circuit board (21) below a housing bottom, respectively.

10. The rocker switch according to claim 9, **characterized in that** the annular magnet (18) is rotationally fixedly secured to the rotary axle (30) and/or to the lug preferably by means of adhering.

11. The rocker switch according to at least one of the preceding claims, in which the switch housing (11) has a lower and an upper housing part (12, 13), **characterized in that** the lower housing part (12) has a frame perpendicularly protecting from the lower side of its bottom, in which the circuit board (21) is disposed attached to the bottom, and that a shielding plate (65) is disposed at least partially within the frame and between circuit board (21) and bottom.

12. The rocker switch according to claim 11, **characterized in that** the shielding plate (65) is overmolded with plastic.

## Revendications

1. Interrupteur à bascule (10), avec une unité mécanique d'interrupteur constituée par un boîtier d'interrupteur (11) à l'intérieur duquel est logé un élément de commande (14) chargé par ressort et apte à être actionné d'un mouvement de va-et-vient, et avec une bascule de manoeuvre (16) reliée audit élément de commande (14), ledit élément de commande (14) présentant un axe de rotation (30) qui est logé à rotation dans ledit boîtier d'interrupteur (11) et qui est entouré d'un ressort à double enroulement en sens opposé (25) qui est tenu de manière précontrainte dans ledit boîtier d'interrupteur (11) et dont l'une des deux branches terminales libres de ressort (27, 29) est logée de façon stationnaire à l'intérieur dudit boîtier d'interrupteur (11) et l'autre est logée sur un premier bras (38) solidaire en rotation dudit axe de rotation (30) et dont une branche de ressort centrale en U (28) qui fait saillie est logée aussi bien de façon stationnaire dans ledit boîtier d'interrupteur (11) que sur un deuxième bras (39) solidaire en rotation de l'axe de rotation (30), ainsi qu'avec une unité électrique d'interrupteur (17), **caractérisé par le fait que**, en état monté, les deux branches terminales libres de ressort (27, 29) et ladite branche de ressort centrale en U (28) qui fait saillie, en étant situées en vis-à-vis les unes des autres par rapport à l'extension longitudinale de l'axe de rotation (30), sont disposées de manière à s'étendre pour l'essentiel dans des plans parallèles.

2. Interrupteur à bascule selon la revendication 1, **caractérisé par le fait que** les deux parties de ressort enroulées en sens opposé (24, 26) du ressort (25) présentent un nombre égal de spires, de préférence de trois spires.

3. Interrupteur à bascule selon la revendication 1 ou 2, **caractérisé par le fait que** celle (24) des parties de ressort enroulées qui est pourvue de la branche terminale de ressort (27) solidaire en rotation de l'axe de rotation (30) est reçue dans une pièce rapportée (36) à peu près en forme de pot et concentrique et fendue axialement sur une zone circonférentielle, de manière à être fixée sur la circonférence extérieure.

4. Interrupteur à bascule selon la revendication 3, **caractérisé par le fait que** ladite pièce rapportée (36) présente un appui tangentiel délimitant extérieurement ladite fente axiale (40) pour la branche terminale de ressort.

5. Interrupteur à bascule selon l'une au moins des revendications 1 à 4, **caractérisé par le fait que** ledit axe de rotation (30) présente un tube métallique (31) qui est revêtu par injection de matière plastique, de préférence sur les faces extérieure et intérieure.

6. Interrupteur à bascule selon la revendication 3 et/ou 4 et la revendication 5, **caractérisé par le fait que** ladite pièce rapportée (36) fait partie du revêtement en matière plastique de l'axe de rotation (30), réalisé par injection.

7. Interrupteur à bascule selon l'une au moins des revendications 3 à 6, **caractérisé par le fait que** ladite pièce rapportée (36) présente, sur une zone circonférentielle, une rallonge axiale et orientée tangentiellement qui forme une surface d'appui pour ladite branche de ressort centrale (28) précontrainte.

8. Interrupteur à bascule selon la revendication 6, **caractérisé par le fait que** la face circonférentielle extérieure dudit tube métallique (31) est logée à l'intérieur du boîtier d'interrupteur (11).

9. Interrupteur à bascule dans lequel ladite unité électrique d'interrupteur (17) comprend un aimant en anneau (18) aimanté de manière permanente et déplaçable avec ledit axe de rotation (30), selon l'une au moins des revendications précédentes, **caractérisé par le fait qu'**audit aimant en anneau (18) sont associés deux capteurs (19, 20) qui, en étant situés en vis-à-vis l'un de l'autre sur les faces supérieure et inférieure respectivement d'une carte à circuits imprimés (21), sont disposés au-dessous d'un fond de boîtier.

10. Interrupteur à bascule selon la revendication 9, **caractérisé par le fait que** ledit aimant en anneau (18) est fixé d'une manière solidaire en rotation, de préférence par collage, sur ledit axe de rotation (30) et/ou sur ladite pièce rapportée.

11. Interrupteur à bascule selon l'une au moins des revendications précédentes, dans lequel ledit boîtier d'interrupteur (11) comprend des parties inférieure et supérieure de boîtier (12, 13), **caractérisé par le fait que** ladite partie inférieure de boîtier (12) présente un cadre qui fait saillie verticalement depuis la face inférieure de son fond et dans lequel la carte de circuits imprimés (21) est disposée de manière à être fixée au fond, et qu'une tôle de blindage (65) est disposée au moins en partie à l'intérieur dudit cadre et entre la carte de circuits imprimés (21) et le fond.

12. Interrupteur à bascule selon la revendication 11, **caractérisé par le fait que** ladite tôle de blindage (65) est revêtue par injection de matière plastique.
